(19) Europäisches Patentamt
European Patent Office
Office européen des brevets

(11) Veröffentlichungsnummer: **0 321 828 B1**

(12) **EUROPÄISCHE PATENTSCHRIFT**

(45) Veröffentlichungstag der Patentschrift: **10.11.93**

(51) Int. Cl.5: **G03F 7/029**

(21) Anmeldenummer: **88120775.7**

(22) Anmeldetag: **13.12.88**

# (54) Photopolymerisierbares Gemisch und daraus hergestelltes Aufzeichnungsmaterial.

(30) Priorität: **22.12.87 DE 3743457**

(43) Veröffentlichungstag der Anmeldung:
**28.06.89 Patentblatt 89/26**

(45) Bekanntmachung des Hinweises auf die Patenterteilung:
**10.11.93 Patentblatt 93/45**

(84) Benannte Vertragsstaaten:
**DE FR GB NL**

(56) Entgegenhaltungen:

| | |
|---|---|
| **EP-A- 0 097 012** | **EP-A- 0 211 615** |
| **DE-A- 2 027 467** | **DE-A- 2 361 041** |
| **DE-A- 2 822 190** | **DE-A- 3 602 093** |
| **FR-A- 2 375 256** | **JP-A-61 228 002** |
| **US-A- 4 399 211** | |

(73) Patentinhaber: **HOECHST AKTIENGESELLSCHAFT**

**D-65926 Frankfurt(DE)**

(72) Erfinder: **Rode, Klaus, Dr.**
**Habelstrasse 5**
**D-6200 Wiesbaden(DE)**
Erfinder: **Mohr, Dieter, Dr.**
**Eaubonner Strasse 8**
**D-6501 Budenheim(DE)**
Erfinder: **Frass, Werner, Dr.**
**Erbsenacker 37**
**D-6200 Wiesbaden-Naurod(DE)**
Erfinder: **Gerstorf, Joachim, Dr.**
**Philip-Holl-Strasse 26**
**D-6200 Wiesbaden(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 321 828 B1

## Beschreibung

Die Erfindung betrifft ein photopolymerisierbares Gemisch, das ein polymeres Bindemittel, eine polymerisierbare Verbindung mit mindestens zwei Acryl- oder Alkacrylsäureestergruppen im Molekül sowie eine Photoinitiatorkombination enthält.

Photopolymerisierbare Gemische, die als polymerisierbare Verbindungen Acryl- und/oder Methacrylsäureester enthalten, sind bekannt. Für die Herstellung von Photoresistmaterialien, insbesondere von Trockenphotoresistschichten, werden dabei Gemische bevorzugt, die Acryl- oder Methacrylsäureester mit Urethangruppen im Molekül enthalten und die sich mit wäßrig-alkalischen Lösungen entwickeln lassen. Derartige Gemische sind z. B. in der DE-A 28 22 190, der DE-B 21 15 373, der DE-C 23 61 041 und den US-A 3 850 770 und 3 960 572 beschrieben.

Andererseits sind auch photopolymerisierbare Gemische bekannt, die zur Erhöhung der Lichtempfindlichkeit bestimmte Kombinationen von Photoinitiatoren und Aktivatoren, z. B. von Carbonylgruppen enthaltenden Initiatoren und tertiären Aminen, enthalten. Derartige synergistisch wirkende Gemische sind z. B. in den DE-A 26 02 419 und 22 51 048 und der US-A 3 759 807 beschrieben. Ein Nachteil dieser Gemische, die niedermolekulare Amine enthalten, besteht darin, daß sie eine geringere Lagerstabilität aufweisen, da die Amine, insbesondere aus dünnen Schichten, leicht ausschwitzen können.

In der JP-A 50/129 214, angemeldet am 2.4.1974 unter der Nummer 49/36614, wird ein photopolymerisierbares Gemisch beschrieben, das als polymerisierbare Verbindung einen Tetra(meth)acrylsäureester eines N,N,N′,N′-Tetrahydroxyalkyl-alkylendiamins enthält. Die tetrafunktionelle Verbindung dient als Vernetzungsmittel.

Es sind auch Gemische bekannt, die als Vernetzer Triethanolamintrimethacrylat enthalten und z. B. in Chem. Abstr. 86 (1977), 30443q und 95 (1981), 220 727u beschrieben sind. Auch diese Verbindungen neigen bei längerer Lagerung und bei erhöhter Umgebungstemperatur dazu, aus der Schicht auszuschwitzen und zu verdampfen.

Es ist weiterhin bekannt, daß man die radikalische Polymerisation von ethylenisch ungesättigten Verbindungen durch Bestrahlung mit sichtbarem Licht in Gegenwart von photoreduzierbaren Farbstoffen und Reduktionsmitteln, z. B. Aminen, anstoßen kann (US-A 3 097 096). Diese Initiatorkombinationen werden jedoch im wesentlichen nur in wäßriger Lösung oder in Kombination mit wasserlöslichen Bindemitteln eingesetzt.

Initiatorkombinationen aus photoreduzierbaren Farbstoffen und anderen Reduktionsmitteln sind in den US-A 3 597 343 und 3 488 269 beschrieben. Photopolymerisierbare Gemische, die als Initiatoren ausschließlich photoreduzierbare Farbstoffe enthalten, sind wegen ihrer zu geringen Lichtempfindlichkeit bisher praktisch nicht eingesetzt worden.

In der JP-A 54/151 024 ist ein photopolymerisierbares Gemisch beschrieben, das eine Initiatorkombination aus einem Merocyaninfarbstoff und einem trihalogenmethylsubstituierten s-Triazin enthält und gegenüber sichtbarem Licht, z. B. einem Argonlaser, empfindlich ist. Die Empfindlichkeit dieser Gemische gegenüber sichtbarem Laserlicht ist jedoch für eine wirtschaftliche Nutzung nicht ausreichend.

Aus der EP-A 211 615 ist ein photopolymerisierbares Gemisch bekannt, das eine Initiatorkombination aus u.a. einem Xanthen- oder Thioxanthenfarbstoff, 2,4,6-Tristrichlormethyl-s-triazin und einem Peroxid enthält und das gegenüber sichtbarem Licht empfindlich ist. Nachteilig an diesem Gemisch ist der Gehalt an Peroxid, das gegen Stoß, Schlag und Hitze empfindlich ist.

In der älteren deutschen Patentanmeldung P 37 10 281.8 wird ein photopolymerisierbares Gemisch vorgeschlagen, das aus einem polymeren Bindemittel, einem Acryl- oder Methacrylsäureester mit mindestens einer photooxydierbaren Gruppe und mindestens einer Urethangruppe im Molekül, einem photoreduzierbaren Farbstoff, einer durch Strahlung spaltbaren Trihalogenmethylverbindung und einer als Photoinitiator wirksamen Acridin-, Phenazin- oder Chinoxalinverbindung besteht. Als photoreduzierbare Farbstoffe werden solche vom Xanthen-, Thiazin-, Pyronin-, Porphyrin- oder Acridintyp beschrieben, die zumeist Salzcharakter haben.

Aufgabe der Erfindung war es, photopolymerisierbare Gemische vorzuschlagen, die sich zur Herstellung von Druckplatten hoher Auflagenleistung und Photoresists mit hoher Resistenz gegen Verarbeitungslösungen im gehärteten Zustand eignen, die sich durch eine hohe Lichtempfindlichkeit im nahen Ultraviolett- und im sichtbaren Spektralbereich auszeichnen und daher insbesondere zur Laserstrahlaufzeichnung im sichtbaren Bereich geeignet sind.

Erfindungsgemäß wird ein photopolymerisierbares Gemisch vorgeschlagen, das als wesentliche Bestandteile

a) ein polymeres Bindemittel,

b) einen Acryl- oder Alkacrylsäureester eines mehrwertigen Alkohols und

c) einen photoreduzierbaren Farbstoff als Photoinitiator enthält.

Das erfindungsgemäße Gemisch ist dadurch gekennzeichnet, daß es ferner

d) eine durch Strahlung spaltbare Trihalogenmethylverbindung enthält,

daß der photoreduzierbare Farbstoff ein Benzoxanthen- oder Benzothioxanthenfarbstoff ist und daß der Acryl- oder Alkacrylsäureester mindestens eine bei Belichtung in Gegenwart des photoreduzierbaren Farbstoffs photooxydierbare Gruppe aufweist.

Gemäß einer bevorzugten Ausführungsform enthält das Gemisch ferner

e) eine als Photoinitiator wirksame Acridin-, Phenazin- oder Chinoxalinverbindung.

Als photooxydierbare Gruppen kommen insbesondere Aminogruppen, Thiogruppen, die auch Bestandteile heterocyclischer Ringe sein können, Enolgruppen und Carboxylgruppen in Kombination mit olefinischen Doppelbindungen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt. Die Verbindungen können ferner eine oder mehrere Urethangruppen enthalten.

Mit Vorteil werden Acryl- und Alkacrylsäureester der Formel I

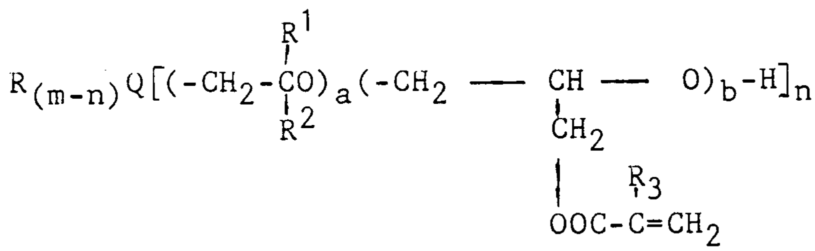

(I)

eingesetzt, worin

Q

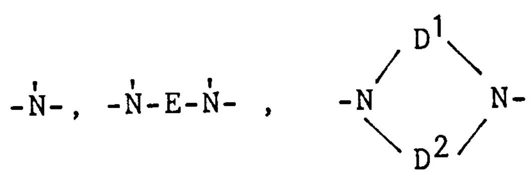

| | |
|---|---|
| | oder -S- , |
| R | eine Alkyl-, Hydroxyalkyl- oder Arylgruppe, |
| $R^1$ und $R^2$ | jeweils ein Wasserstoffatom, eine Alkylgruppe oder Alkoxyalkylgruppe, |
| $R^3$ | ein Wasserstoffatom, eine Methyl- oder Ethylgruppe, |
| $D^1$ und $D^2$ | jeweils eine gesättigte Kohlenwasserstoffgruppe mit 1 bis 5 Kohlenstoffatomen, |
| E | eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen, eine heterocyclische aromatische Gruppe mit 5 oder 6 Ringgliedern oder eine Gruppe der Formel II |

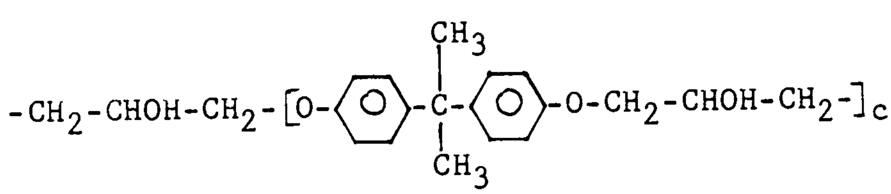

(II),

| | |
|---|---|
| a | Null oder eine ganze Zahl von 1 bis 4, |
| b | eine ganze Zahl von 1 bis 4, |
| c | eine ganze Zahl von 1 bis 3, |

| | |
|---|---|
| m | je nach Wertigkeit von Q 2, 3 oder 4 und |
| n | eine ganze Zahl von 1 bis m |

bedeutet, wobei alle Reste gleicher Definition untereinander gleich oder verschieden sein können.

Die Verbindungen dieser Formel, ihre Herstellung und Verwendung sind ausführlich in der älteren Patentanmeldung P 37 38 864.9 beschrieben.

In der gleichzeitig eingereichten Patentanmeldung P 37 43 455.1 (Hoe 87/K083) sind photopolymerisierbare Gemische beschrieben, die diese polymerisierbaren Verbindungen in Kombination mit photoreduzierbaren Farbstoffen und durch Strahlung spaltbaren Trihalogenmethylverbindungen als Photoinitiatorsysteme enthalten.

In der weiteren gleichzeitig eingereichten Patentanmeldung P 37 43 454.3 (Hoe 87/K082) sind photopolymerisierbare Gemische beschrieben, die diese polymerisierbaren Verbindungen in Kombination mit bestimmten photoreduzierbaren Farbstoffen, durch Strahlung spaltbaren Trihalogenmethylverbindungen und Acridin-, Phenazin- oder Chinoxalinverbindungen als Photoinitiatorsysteme enthalten.

Mit Vorteil werden auch Acryl- und Alkacrylsäureester der Formel III

$$R_{(m-n)}Q[(-CH_2-\overset{R^1}{\underset{R^2}{C}}O)_a-CONH(X^1-NHCOO)_{b'}-X^2(-OOC-\overset{R^3}{C}=CH_2)_c]_n$$

(III)

eingesetzt, worin

$D^1$, $D^2$, E, Q, R, $R^1$, $R^2$, $R^3$, a, c, m und n die gleiche Bedeutung wie in Formel I haben,

| | |
|---|---|
| $X^1$ | eine gesättigte Kohlenwasserstoffgruppe mit 2 bis 12 Kohlenstoffatomen, |
| $X^2$ | eine (c + 1)-wertige gesättigte Kohlenwasserstoffgruppe, in der bis zu 5 Methylengruppen durch Sauerstoffatome ersetzt sein können und |
| b' | 0 oder 1 |

bedeutet, wobei alle Reste gleicher Definition untereinander gleich oder verschieden sein können.

Die Verbindungen dieser Formel, ihre Herstellung und Verwendung sind ausführlich in der älteren deutschen Patentanmeldung P 37 10 279.6 beschrieben.

In der weiteren älteren deutschen Patentanmeldung P 37 10 281.8 sind photopolymerisierbare Gemische beschrieben, die diese polymerisierbaren Verbindungen in Kombination mit bestimmten photoreduzierbaren Farbstoffen, durch Strahlung spaltbaren Trihalogenmethylverbindungen und Acridin-, Phenazin- oder Chinoxalinverbindungen als Photoinitiatorsysteme enthalten.

Wenn in den Verbindungen der allgemeinen Formeln I und III mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Im allgemeinen ist in nicht mehr als einem Rest a = 0; vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatome substituiert sein.

Wenn $R^1$ und $R^2$ Alkyl- oder Alkoxyalkylgruppen sind, können diese je 1 bis 5 Kohlenstoffatome enthalten.

$R^3$ ist bevorzugt ein Wasserstoffatom oder eine Methylgruppe, insbesondere eine Methylgruppe.

$D^1$ und $D^2$ können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

$X^1$ ist bevorzugt ein geradkettiger oder verzweigter aliphatischer oder cycloaliphatischer Rest mit vorzugsweise 4 bis 10 Kohlenstoffatomen.

$X^2$ hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12,

vorzugsweise 2 bis 6 Kohlenstoffatomen eingesetzt. $X^2$ kann auch eine cycloaliphatische Gruppe mit 5 bis 10 Kohlenstoffatomen, insbesondere eine Cyclohexylgruppe sein.

Der Wert von c ist vorzugsweise 1.

Die polymerisierbaren Verbindungen der Formel I mit Q = N und n = m werden hergestellt, indem Acryl- oder Alkacrylsäureglycidylester in bekannter Weise in Gegenwart eines basischen Katalysators, z. B. Natrium oder Natriumhydrid, mit Hydroxyalkylaminen umgesetzt werden. Die Umsetzung kann analog zu der in der DE-A 29 27 933 oder der DE-B 18 00 462 beschriebenen Umsetzung von Glycidyl(meth)acrylat mit Alkoholen durchgeführt werden.

Die als Ausgangsstoffe verwendeten Hydroxyalkylamine sind bekannt oder analog bekannten Verbindungen herzustellen. Beispiele sind Verbindungen, die durch Anlagerung von Ethylenoxid bzw. von höheren Alkylenoxiden an Ammoniak oder Amine entstehen; z. B. Triethanolamin, N-Alkyl-N,N-di(hydroxyalkyl)amine, Diethanolamin, Tris-(2-hydroxypropyl)amin oder Tris-(2-hydroxybutyl)amin.

Die polymerisierbaren Verbindungen der Formel III mit Q = N und n = m, die zwei Urethangruppen in jedem Rest (b′ = 1) enthalten, werden dargestellt, indem Acryl- oder Alkylacrylsäureester, die freie Hydroxygruppen enthalten, in bekannter Weise mit der gleichen Molmenge an Diisocyanaten umgesetzt werden und die überschüssige Isocyanatgruppe mit Hydroxyalkylaminen umgesetzt wird. Wenn a = 0 ist, entsteht eine Harnstoffgruppierung.

Die polymerisierbaren Verbindungen der Formel III mit b′ = 0 werden dargestellt, indem die oben beschriebenen Hydroxyalkylamine mit Isocyanatgruppen enthaltenden Acryl- oder Alkylacrylsäureestern umgesetzt werden. Als Isocyanatgruppen enthaltender Ester wird insbesondere Isocyanatoethyl(meth)acrylat eingesetzt.

Die polymerisierbaren Verbindungen der Formeln I und III mit

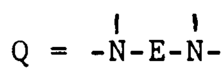

und n = 4

werden analog den polymerisierbaren Verbindungen mit Q = N hergestellt. Die als Ausgangsstoffe verwendeten Tetrahydroxyalkyl-alkylendiamine sind bekannt oder analog zu bekannten Verbindungen herzustellen. Beispiele sind Verbindungen, die durch Anlagerung von Ethylenoxid oder höheren Alkylenoxiden an Diaminoverbindungen entstehen, z. B. an Ethylendiamin und andere Alkylendiamine mit bis zu 12, vorzugsweise bis zu 6 Kohlenstoffatomen im Alkylenrest, p-Phenylendiamin, Benzidin, Diaminopyridine, Diaminopyrimidine oder Diaminopurine.

Die polymerisierbaren Verbindungen der Formeln I und III mit

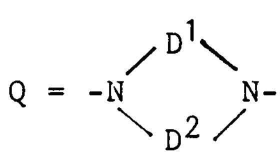

werden analog den oben beschriebenen polymerisierbaren Verbindungen hergestellt. Die als Ausgangsstoffe verwendeten N-Hydroxyalkylheterocyclen sind bekannt oder analog zu bekannten Verbindungen herzustellen. Beispiele sind Umsetzungsprodukte des Ethylenoxids mit Piperazin, 1,4-Diazacycloheptan, 1,10-Diaza-4,7,13,16-tetraoxacyclooctadecan.Insbesondere wird Piperazin eingesetzt, da es der einfachste Vertreter dieser Verbindungsgruppe ist.

Die Umsetzung der Isocyanate mit den OH-Gruppen enthaltenden Aminen und Alkylacrylaten und die Umsetzung der Acryl- oder Alkacrylsäureglycidylester mit den OH-Gruppen enthaltenden Aminen wird zweckmäßig in einem inerten Lösemittel wie Toluol oder Methylethylketon durchgeführt. Zur thermischen Stabilisierung der stark zur Polymerisation neigenden Produkte werden Chinone, vorzugsweise Benzochinon, in Konzentrationen von 0,01 - 2 Gew.-% zugesetzt.

Die Verbindungen mit Q = S werden, ausgehend vom entsprechenden Bis-hydroxyalkyl-sulfid, analog den oben angegebenen allgemeinen Vorschriften hergestellt.

Neben anderen Bestandteilen sind die vorstehend beschriebenen polymerisierbaren Verbindungen für die sehr hohe Lichtempfindlichkeit der photopolymerisierbaren Gemische verantwortlich.

Außer den beschriebenen photooxydierbaren polymerisierbaren Verbindungen können auch herkömmliche polymerisierbare Verbindungen, die zwei oder mehr polymerisierbare Acryl- oder Methacrylsäureestergruppen enthalten, zugesetzt werden. Beispiele sind Acryl- und Methacrylsäureester von zwei-oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079, 23 61 041 und 28 22 190 beschrieben.

Der Mengenanteil des Gemischs an Monomeren beträgt im allgemeinen etwa 10 bis 80, vorzugsweise 20 bis 60 Gew.-%.

Das erfindungsgemäße Gemisch enthält als Photoinitiatorbestandteil einen photoreduzierbaren Farbstoff. Geeignete Farbstoffe sind Benzoxanthen- oder Benzothioxanthenfarbstoffe. Bevorzugte Vertreter dieser Farbstoffe sind Verbindungen der allgemeinen Formel IV

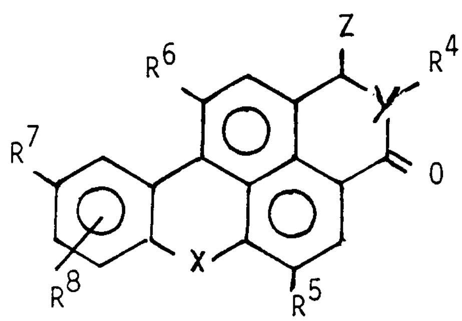

(IV)

worin

| | |
|---|---|
| $R^4$ | einen ggf. substituierten Alkyl-, Hydroxyalkyl-, Dialkylaminoalkyl- oder Arylrest, |
| $R^5$ und $R^6$ | Wasserstoff- oder Halogenatome oder ggf. substituierte Alkoxyreste, |
| $R^7$ und $R^8$ | Wasserstoff- oder Halogenatome, Nitril-, Alkyl-, Alkoxy-, Aryl- oder Alkoxycarbonylreste, |
| X | ein Sauerstoff- oder Schwefelatom und |

entweder

Y ein Kohlenstoffatom und

Z eine Hydroxygruppe, einen ggf. substituierten Alkyl-, Alkoxy- oder Acyloxyrest, wobei zwischen Y und dem Y und Z verbindenden C-Atom eine Doppelbindung vorliegt,

oder

Y ein Stickstoffatom und

Z ein Carbonylsauerstoffatom bedeutet, wobei zwischen Y und dem Y und Z verbindenden C-Atom eine Einfachbindung vorliegt.

Farbstoffe mit Y = C und ihre Herstellung sind in der DE-A 20 25 291 beschrieben. Die entsprechenden Verbindungen mit Y = N werden aus den dort angegebenen Ausgangsstoffen in analoger Weise hergestellt.

Wenn die Reste $R^4$, $R^5$ und $R^6$ Substituenten tragen, sind dies vorzugsweise Halogenatome, Alkyl-Alkoxy-, Acyl- oder Acyloxygruppen mit 1 bis 4 Kohlenstoffatomen.

Soweit die Reste $R^4$, $R^5$, $R^6$, $R^7$ und $R^8$ Alkylgruppen sind oder solche enthalten, haben diese vorzugsweise 1 bis 10, insbesondere 1 bis 5 Kohlenstoffatome. Als Halogenatome werden Chlor- oder Bromatome bevorzugt.

Als Arylreste kommen im allgemeinen bis zu 3-kernige, vorzugsweise Phenylreste in Betracht: Acylreste sind vorzugsweise Alkanoylreste.

Die Menge der Komponente (c) des Gemischs liegt im allgemeinen zwischen 0,01 und 10, vorzugsweise zwischen 0,05 und 4 Gew.-%, bezogen auf die nichtflüchtigen Anteile des Gemischs.

Zur Steigerung der Lichtempfindlichkeit enthalten die erfindungsgemäßen Gemische Verbindungen mit photolytisch spaltbaren Trihalogenmethylgruppen (d), die als radikalbildende Photoinitiatoren für photopolymerisierbare Gemische an sich bekannt sind. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2

Trihalogenmethylgruppen trägt, insbesondere solche, wie sie in der EP-A 137 452, der DE-A 27 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyl-tribrommethylsulfon, sind geeignet. Ferner eignen sich Trihalogenmethylgruppen enthaltende Carbonylmethylenheterocyclen, wie sie in der DE-A 33 33 450 beschrieben sind.

Die Komponenten (d) werden im allgemeinen in einer Menge von 0,01 bis 10, vorzugsweise von 0,05 bis 6 Gew.-%, bezogen auf die nichtflüchtigen Bestandteile des Gemischs, eingesetzt.

Die erfindungsgemäßen Gemische enthalten bevorzugt als weiteren Initiatorbestandteil eine Acridin-, Phenazin- oder Chinoxalinverbindung (e). Diese Verbindungen sind als Photoinitiatoren bekannt und in den DE-C 20 27 467 und 20 39 861 beschrieben. Durch diese Verbindungen wird die Empfindlichkeit des Gemischs vor allem im nahen Ultraviolettbereich gesteigert. Geeignete Vertreter dieser Verbindungsklasse sind in den genannten DE-C beschrieben. Beispiele sind in 9-Stellung substituierte Acridine, wie 9-Phenyl-, 9-p-Methoxyphenyl- oder 9-Acetylamino-acridin, oder Acridinderivate mit ankondensierten aromatischen Kernen, z. B. Benz(a)acridin. Als Phenazinderivat ist z. B. das 9,10-Dimethyl-benz(a)phenazin geeignet.

Als Chinoxalinderivate kommen insbesondere die 2,3-Diphenylderivate in Betracht, die vorzugsweise in den beiden Phenylresten durch Methoxygruppen weiter substituiert sind. Im allgemeinen werden als Komponenten (e) die Acridinderivate bevorzugt.

Die Menge der Komponente (e) im Gemisch liegt gegebenenfalls im Bereich von 0,01 bis 10 Gew.-%, vorzugsweise zwischen 0,05 und 5 Gew.-%.

Die Gesamtmenge an Polymerisationsinitiatoren (c), (d) und (e) liegt im allgemeinen bei 0,05 bis 20, vorzugsweise bei 0,1 bis 10 Gew.-%. Das Molverhältnis der Bestandteile (c), (d) und (e) untereinander liegt bevorzugt in den folgenden Bereichen

(c) : (d) : (e) = 1 : (0,1-5) : (0-4)

Als Bindemittel können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid und Mischpolymerisate der Monomeren, die die aufgezählten Homopolymerisate bilden, sowie Blockmischpolymerisate von Vinylaromaten, z. B. Styrol, und Dienen, z. B. Butadien oder Isopren.

Mit Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrigalkalischen Entwicklern entwickeln lassen. Derartige Bindemittel können z. B. die folgenden Gruppen enthalten: $-COOH$, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 30 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher, Regler für die Lichtempfindlichkeit, wie bestimmte Chalkon- oder Cumarinderivate, und Kettenüberträger. Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet. Als Anwendungsmöglichkeiten auf diesem Gebiet seien genannt: Aufzeichnungsschichten für die photomechanische Herstellung von Druckformen für den Hochdruck, den Flexodruck, den Flachdruck, den Tiefdruck, den Siebdruck, von Reliefkopien, z. B. von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Druckplatten und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckplatten, vorliegen. Ebenso ist es für die Herstellung von Trockenresist geeignet.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyamide, Polyvinylalkohol, Polyphosphate, Zucker usw.. Solche Deckschichten haben im allgemeinen eine Dicke von 0,1 bis 10, vorzugsweise 1 bis 5 µm.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Cellulosacetat, sowie Siebdruckschablonenträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man dieses in einem Lösemittel aufnehmen und die Lösung bzw. Dispersion durch Gießen, Sprühen, Tauchen, Antrag mit Walzen usw. auf den vorgesehenen Träger aufbringen und anschließend trocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und getrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Durch die breite spektrale Empfindlichkeit des erfindungsgemäßen Gemisches können alle dem Fachmann geläufigen Lichtquellen verwendet werden, z. B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Ausführungsbeispiele für die Erfindung angegeben. Dabei wird zunächst in Tabelle I eine Anzahl von polymerisierbaren Verbindungen der Formeln I und III aufgeführt, die in den Beispielen eingesetzt werden.

Die Herstellung dieser Verbindungen erfolgt nach einem der vorstehend angegebenen Verfahren. Die Verbindungen werden in den nachfolgenden Beispielen in erfindungsgemäßen Aufzeichnungsmaterialien als polymerisierbare Verbindungen eingesetzt. In den Beispielen stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

## Tabelle I

Verbindungen der allgemeinen Formel I mit $R^2$=H; $R^3$=$CH_3$; m=n; a=1;

| Verb. Nr. | Q | $R^1$ | m |
|---|---|---|---|
| 1 | -N- | H | 3 |
| 2 | $-N-CH_2-CH_2-N-$ | $CH_3$ | 4 |
| 3 | -S- | H | 2 |
| 4 | *) | H | 4 |

*) 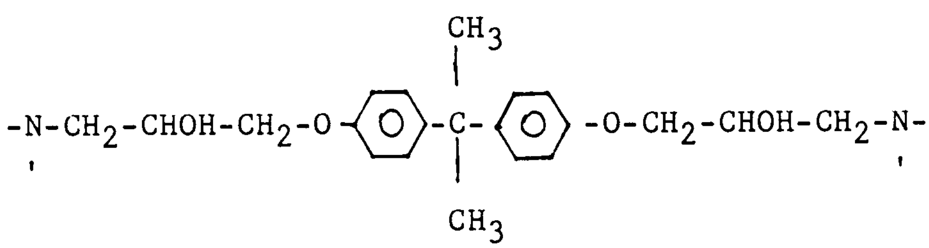

## Tabelle II

Verbindungen der allgemeinen Formel III mit
$R^2=H$; $R^3=CH_3$; $X^2=C_2H_4$; m=n; a=1

| Verb. Nr. | Q | $R^1$ | $X^1$ | b | m |
|---|---|---|---|---|---|
| 5 | -N- | H | Hexamethylen | 1 | 3 |
| 6 | $-N-CH_2-CH_2-N-$ | $CH_3$ | - | 0 | 4 |
| 7 | -N- | H | - | 0 | 3 |

Beispiele 1 bis 10

Als Schichtträger für Druckplatten wurde elektrochemisch aufgerauhtes und anodisiertes Aluminium mit einer Oxidschicht von 3 $g/m^2$ verwendet, das mit einer wäßrigen Lösung von Polyvinylphosphonsäure vorbehandelt worden war. Der Träger wurde mit Lösungen folgender Zusammensetzung überzogen:

2,87 Gt einer 34,8 %igen Lösung eines Mischpolymerisats aus Methylmethacrylat und Methacrylsäure mit der Säurezahl 110 und dem mittleren Molekulargewicht 35 000 in Butanon,
1,0 Gt Verbindung 1 und
0,03 Gt 2,4-Bis-trichlormethyl-6-(4-styrylphenyl)-s-triazin in
22 Gt Propylenglykolmonomethylether.

Jeder Beschichtungslösung wurde ein Farbstoff gemäß Formel IV in der in Tabelle III angegebenen Menge zugesetzt. Das Auftragen erfolgte durch Aufschleudern in der Weise, daß ein Trockengewicht von 1,8 bis 2 $g/m^2$ erhalten wurde. Anschließend wurden die Platten zwei Minuten bei 100° C im Umlufttrockenschrank getrocknet. Die Platten wurden dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 4 bis 5 $g/m^2$ erhalten. Die erhaltenen Druckplatten wurden mittels einer 5 kW-Metallhalogenidlampe im Abstand von 110 cm unter einem 13-stufigen Belichtungskeil mit Dichteinkrementen von 0,15 belichtet, auf den, soweit angegeben, zusätzlich ein Silberfilm mit gleichmäßiger Schwärzung (Dichte 1,57) und gleichmäßiger Absorption über den wirksamen Spektralbereich als Graufilter montiert wurde. Um die Empfindlichkeit der Druckplatten im sichtbaren Licht zu testen, wurden auf den Belichtungskeil jeweils 3 mm starke Kantenfilter der Firma Schott mit den in der Tabelle angegebenen Kantendurchlässigkeiten montiert. Nach der Belichtung wurden die Platten eine Minute auf 100° C erwärmt. Anschließend wurden sie mit einem Entwickler folgender Zusammensetzung entwickelt:

8,5 Gt Natriummetasilikat x 9 $H_2O$,
0,8 Gt NaOH und
1,5 Gt $Na_2B_4O_7$ x 10 $H_2O$ in
89,2 Gt vollentsalztem Wasser.

Die Platten wurden mit fetter Druckfarbe eingefärbt. Es wurden die in Tabelle III angegebenen vollvernetzten Keilstufen erhalten:

Tabelle III

| Beispiel Nr. | Farbstoff gemäß Formel I mit $R^5 = R^6 = R^8 = H$ | | Menge (g) | Belichtungszeit (s) | Graufilter | Kantenfilter | Keilstufen |
|---|---|---|---|---|---|---|---|
| 1 - 8 | $R^7 = OCH_3$; X = O; Y = C | | | | | | |
| | $R^4$ | Z | | | | | |
| 1 | $4-C_6H_4OH$ | OH | 0,02 | 20 | ja | - | 5 |
| | | | | " | nein | 455 | 4 |
| 2 | $C_6H_5$ | $CH_3COO$ | " | " | ja | - | 4 |
| | | | | " | nein | 455 | 4 |
| 3 | $4-CH_3COOC_6H_4$ | " | " | " | ja | - | 7 |
| | | | | " | nein | 455 | 4 |
| 4 | $C_6H_5$ | $C_2H_5O$ | " | " | ja | - | 5 |
| | | | | " | nein | 455 | 3 |
| 5 | $4-C_2H_5OC_6H_4$ | " | " | " | ja | - | 5 |
| | | | | " | nein | 455 | 4 |
| 6 | $C_6H_5$ | $n-C_4H_9O(C_2H_4O)_2$ | " | " | ja | - | 8 |
| | | | | " | nein | 455 | 10 |
| 7 | $4-n-C_4H_9O(C_2H_4O)_2C_6H_4$ | " | " | " | ja | - | 6 |
| | | | | " | nein | 455 | 5 |
| 8 | $C_6H_5$ | OH | " | " | ja | - | 7 |
| | | | | " | nein | 455 | 9 |

Tabelle III

| Beispiel Nr. | Farbstoff gemäß Formel I mit $R^5 = R^6 = R^8 = H$ | Menge (g) | Belichtungs-zeit (s) | Grau-filter | Kanten-filter | Keil-stufen |
|---|---|---|---|---|---|---|
| 9 | $X=S$; $Y=C$; $R^7=H$; $R^4=C_6H_5$; $Z=CH_3COO$ | 0,06 | 1 | ja | - | 1 |
| | | | 1 | nein | 455 | 3 |
| 10 | $X=O$; $Y=N$; $Z=O$; $R^7=OCH_3$; $R^4=HO(CH_2)_5$ | 0,02 | 20 | ja | - | 7 |
| | | | " | nein | 455 | 7 |

Wenn Proben der Deckschichten nach 1 Stunde Lagerung bei 100 °C von den lichtempfindlichen Schichten abgezogen wurden, zeigten sie keine Färbung durch Diffusion der eingesetzten Farbstoffe.

Beispiel 11

Auf den in den Beispielen 1 - 10 angegebenen Schichtträger wurde unter gleichen Bedingungen wie dort eine Lösung folgender Zusammensetzung so aufgeschleudert, daß ein Schichtgewicht von 2 $g/m^2$ erhalten wurde:
2,84 Gt der in den Beispielen 1 - 10 angegebenen Copolymerisatlösung,
1,0 Gt Verbindung 1,
0,06 Gt Farbstoff,
0,03 Gt des in den Beispielen 1 - 10 angegebenen s-Triazins und
0,04 Gt 9-Phenylacridin in
22,0 Gt Propylenglykolmonomethylether.

Der Farbstoff war eine Verbindung der Formel IV mit X = S; Y = C; Z = $CH_3O$; $R^4$ = Phenyl; $R^5 = R^6 = R^7 = R^8 = H$
Nach Auftragen einer Deckschicht aus Polyvinylalkohol wurde die Platte in gleicher Weise wie in den Beispielen 1 - 10 belichtet und entwickelt. Eine gleiche Platte wurde hergestellt, jedoch ohne Zusatz von Phenylacridin. Es wurde die folgende Anzahl vollvernetzter Keilstufen erhalten:

| Belichtung (Sekunden) | Graufilter | Kantenfilter | Keilstufen | |
|---|---|---|---|---|
| | | | mit | ohne |
| | | | Phenylacridin | |
| 5 | ja | - | 4 | 2 |
| 5 | nein | 455 | 9 | 7 |

Beispiel 12

Auf den in Beispiel 1 angegebenen Schichtträger wurde eine Lösung folgender Zusammensetzung so aufgeschleudert, daß ein Schichtgewicht von 2,5 $g/m^2$ erhalten wurde:
2,87 Gt der in den Beispiel 1 - 10 angegebenen Copolymerisatlösung,
1,0 Gt Verbindung 1,
0,06 Gt Farbstoff aus Beispiel 11 und
0,03 Gt Halogenverbindung in
22,0 Gt Propylenglykolmonomethylether.

Die Platten wurden in gleicher Weise wie im Beispiel 1 verarbeitet. Nach 20 Sekunden Belichtungszeit wurde die folgende Anzahl vollvernetzter Keilstufen erhalten:

| Halogenverbindung | Graufilter | Kantenfilter | Stufen |
|---|---|---|---|
| 2-(4-Trichlormethylbenzoylmethylen)-3-ethylbenzothiazolin | ja | - | 4 |
| | nein | 455 | 7 |
| Phenyl-tribrommethylsulfon | ja | - | 3 |
| | nein | 455 | 9 |

Beispiel 13

Auf den in den Beispielen 1 - 10 angegebenen Schichtträger wurden Lösungen folgender Zusammensetzung so aufgeschleudert, daß Schichtgewichte von 2,0 $g/m^2$ erhalten wurden:
2,29 Gt einer 30,05 %igen Lösung eines Terpolymerisats aus Styrol, n-Hexylmethacrylat und Methylacrylsäure (10:60:30) mit der Säurezahl 190 in Methylethylketon,
1,0 Gt Monomeres gemäß Tabelle IV,
0,06 Gt des in Beispiel 11 angegebenen Farbstoffs und
0,03 Gt 2,4-Bis-trichlormethyl-6-(4-styrylphenyl)-s-triazin in
22 Gt Propylenglykolmonomethylether.

Die Platten wurden wie in den Beispielen 1-10 verarbeitet, und es wurde die in Tabelle IV angegebene Anzahl vollvernetzter Keilstufen erhalten.

Tabelle IV

| Verbindung | Belichtung (Sekunden) | Graufilter | Kantenfilter | Keilstufen |
|---|---|---|---|---|
| 1 | 10<br>10 | ja<br>nein | -<br>455 | 4<br>9 |
| 2 | 5<br>5 | ja<br>nein | -<br>455 | 2<br>7 |
| 3 | 20<br>20 | ja<br>nein | -<br>455 | 3<br>6 |
| 4 | 20<br>20 | ja<br>nein | -<br>455 | 4<br>9 |
| 5 | 20<br>20 | ja<br>nein | -<br>455 | 3<br>8 |
| 6 | 20<br>20 | ja<br>nein | -<br>455 | 1<br>4 |
| 7 | 10<br>10 | ja<br>nein | -<br>455 | 3<br>7 |

Um zu zeigen, daß die erfindungsgemäße Kombination praxisgerechter ist als die in der EP-A 211 615 beschriebene, wurde auf den in den Beispielen 1-10 angegebenen Schichtträger nach den Angaben der EP-A 211 615 folgende Lösung so aufgeschleudert, daß ein Schichtgewicht von 1,8-2 g/m$^2$ erhalten wurde:
2,87 Gt der in den Beispielen 1-10 angegebenen Copolymerisatlösung,
1,0 Gt Pentaerythrittriacrylat, 0,06 Gt des in Beispiel 11 angegebenen Farbstoffs,
0,03 Gt N-Phenylglycin,
0,06 Gt 2,5-Dimethyl-pentan-2,5-bis-tert.-butylperoxid,
20,0 Gt Butanon
3,75 Gt Propylenglykolmonomethylether.

Die beschichtete Platte wurde wie in der EP-A 211 615 beschrieben verarbeitet. Nach 10 Sekunden Belichtungszeit und Entwicklung mit dem in den Beispielen 1-10 angegebenen Entwickler erhielt man weder unter dem Graufilter noch unter dem Kantenfilter eine vollständig durchgehärtete Stufe.

Beispiel 14

Die Druckplatte aus Beispiel 9, jedoch mit einem Farbstoff der allgemeinen Formel IV mit X = S; Y = C; Z = $CH_3COO$; $R^4 = C_6H_5$; $R^5 = R^6 = R^7 = R^8 = H$ wurde mit dem aufgeweiteten Strahl eines Argon-Ionen-Lasers belichtet und wie in Beispiel 1 weiterverarbeitet.

Die Belichtungsergebnisse waren wie folgt:

| Wellenlänge (nm) | Energie im Laserstrahl (mW/cm$^2$) | Belichtungszeit (Sekunden) |
|---|---|---|
| 488,0 | 0,225 | 20 |

Mit dieser Platte durchgeführte Druckversuche lieferten über 100.000 einwandfreie Drucke.

Beispiel 15

Auf den in den Beispielen 1-10 angegebenen Schichtträger wurde eine Lösung folgender Zusammensetzung so aufgeschleudert, daß ein Schichtgewicht von 2,0 g/m$^2$ erhalten wurde:
2,29 Gt der in Beispiel 13 angegebenen Terpolymerisatlösung,

0,5 Gt Verbindung 1,
0,97 Gt einer 51,2 %igen Lösung des Umsetzungsprodukts von 1 mol 2,2,4-Trimethylhexamethylendiisocyanat mit 2 mol Hydroxyethylmethacrylat in Butanon,
0,06 Gt des Farbstoffs aus Beispiel 11 und
0,03 Gt 2,4-Bis-trichlormethyl-6-(4-styryl-phenyl)-s-triazin in
22,0 Gt Propylenglykolmonomethylether.

Die Platte wurde in gleicher Weise wie in den Beispielen 1-10 verarbeitet. Nach 20 Sekunden Belichtung wurde jeweils die folgende Anzahl vollvernetzter Keilstufen erhalten:

| Graufilter | Kantenfilter | Stufen |
|---|---|---|
| ja | - | 3 |
| nein | 455 | 7 |

Beispiel 16

Auf den in den Beispielen 1-10 angegebenen Schichtträger wurden unter gleichen Bedingungen wie dort Lösungen folgender Zusammensetzung aufgeschleudert:
2,87 Gt der in den Beispielen 1-10 angegebenen Copolymerisatlösung,
1,0 Gt Verbindung 1,
0,06 Gt des Farbstoffs aus Beispiel 11,
0,03 Gt 2,4-Bis-trichlormethyl-6-(4-styryl-phenyl)-s-triazin und
0,05 Gt Carbonylverbindung in
22,0 Gt Propylenglykolmonomethylether

Die beschichteten Platten wurden wie in den Beispielen 1-10 getrocknet und mit einer Deckschicht versehen. Die Belichtung erfolgte unter einem Interferenz-Verlauffilter von 400 bis 700 nm mit parallelem Licht einer 500 W-Glühbirne im Abstand von 55 cm. Nach Verarbeitung wie in den Beispielen 1-10 wurde in den angegebenen Spektralbereichen vollständige Aushärtung gefunden:

| Carbonylverbindung | Belichtungszeit (Sekunden) | Spektralbereich (nm) |
|---|---|---|
| 4-Dimethylamino-4′-methoxy-dibenzalaceton | 30 | 410-600 |
| 3-Acetyl-7-diethylamino-cumarin | 30 | 420-605 |

Ohne Carbonylverbindung erhielt man nach 30 Sekunden einen ausgehärteten Bereich von 450-590 nm.

Die Wirksamkeit der zugesetzten Verbindungen hinsichtlich des Auflösungsvermögens wurde mit einer Testvorlage, dem FOGRA-PMS-Keil, bestimmt und an der Kopie abgelesen. Das oben angegebene Gemisch ohne Dibenzalaceton- oder Cumarinderivat ergab jeweils eine um mindestens eine Stufe im K-Feld der Testvorlage schlechtere Auflösung.

Beispiel 17

Die Beschichtungslösung aus Beispiel 4 mit Verbindung 7 wurde auf eine biaxial verstreckte 35 µm dicke Polyethylenterephthalatfolie so aufgeschleudert, daß nach dem Trocknen ein Schichtgewicht von 5 g/m$^2$ erhalten wurde. Die Schicht wurde 4 Minuten bei 100° C im Umlufttrockenschrank nachgetrocknet. Anschließend wurde die Schicht bei 115° C mit 1,5 m/s auf einen gereinigten Träger laminiert, der aus einem Isoliermaterial mit 35 µm Kupferauflage bestand.

Die Schicht wurde mittels einer 5 kW-Metallhalogenidlampe (140 cm Abstand) unter einem Kantenfilter 455, wie im Beispiel 1 beschrieben, und unter einem Stufenkeil 40 Sekunden belichtet, 1 Minute auf 100° C nacherwärmt und nach Abziehen der Folie mit 0,8 %iger Sodalösung in einem Sprühprozessor 20 Sekunden entwickelt. Es wurden 7 vollvernetzte Keilstufen erhalten. Die vernetzte Schicht war gegen die in der Leiterplattentechnik übliche Eisen-III-chlorid-Lösung resistent. Die Ätzfestigkeit war gut.

## Patentansprüche

1. Photopolymerisierbares Gemisch, das als wesentliche Bestandteile
   a) ein polymeres Bindemittel,
   b) einen Acryl- oder Alkacrylsäureester eines mehrwertigen Alkohols und
   c) einen photoreduzierbaren Farbstoff als Photoinitiator

   enthält, dadurch gekennzeichnet, daß es ferner
   d) eine durch Strahlung spaltbare Trihalogenmethylverbindung enthält,

   daß der photoreduzierbare Farbstoff ein Benzoxanthen- oder Benzothioxanthenfarbstoff ist und daß der Acryl- oder Alkacrylsäureester mindestens eine bei Belichtung in Gegenwart des photoreduzierbaren Farbstoffs photooxydierbare Gruppe aufweist.

2. Gemisch nach Anspruch 1, dadurch gekennzeichnet, daß der Acryl- oder Alkacrylsäureester eine Verbindung der Formel I

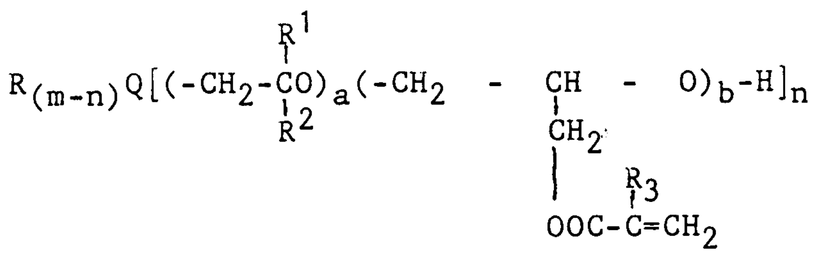
(I)

ist, worin

Q

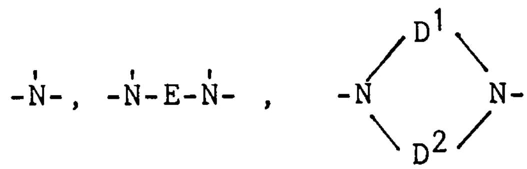

| | |
|---|---|
| | oder -S- , |
| R | eine Alkyl-, Hydroxyalkyl- oder Arylgruppe, |
| $R^1$ und $R^2$ | jeweils ein Wasserstoffatom, eine Alkylgruppe oder Alkoxyalkylgruppe, |
| $R^3$ | ein Wasserstoffatom, eine Methyl- oder Ethylgruppe, |
| $D^1$ und $D^2$ | jeweils eine gesättigte Kohlenwasserstoffgruppe mit 1 bis 5 Kohlenstoffatomen, |
| E | eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen, eine heterocyclische aromatische Gruppe mit 5 oder 6 Ringgliedern oder eine Gruppe der Formel II |

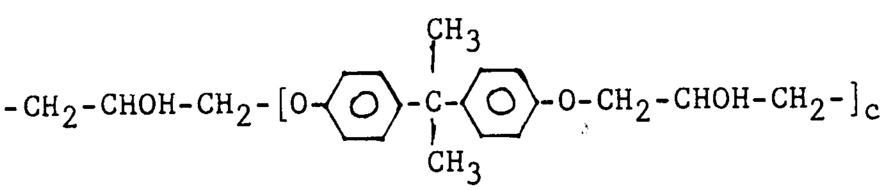
(II),

| | |
|---|---|
| a | Null oder eine ganze Zahl von 1 bis 4, |
| b | eine ganze Zahl von 1 bis 4, |
| c | eine ganze Zahl von 1 bis 3, |
| m | je nach Wertigkeit von Q 2, 3 oder 4 und |
| n | eine ganze Zahl von 1 bis m |

bedeutet, wobei alle Reste gleicher Definition untereinander gleich oder verschieden sein können.

**3.** Gemisch nach Anspruch 1, dadurch gekennzeichnet, daß der Acryl- oder Alkacrylsäureester eine Verbindung der Formel III

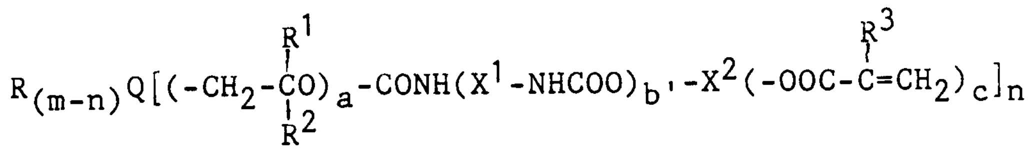

(III)

ist, worin $D^1$, $D^2$, E, Q, R, $R^1$, $R^2$, $R^3$, a, c, m und n die gleiche Bedeutung wie in Formel I von Anspruch 2 haben,

- $X^1$ eine gesättigte Kohlenwasserstoffgruppe mit 2 bis 12 Kohlenstoffatomen,
- $X^2$ eine (c+1)-wertige gesättigte Kohlenwasserstoffgruppe, in der bis zu 5 Methylengruppen durch Sauerstoffatome ersetzt sein können, und
- b′ 0 oder 1

bedeutet, wobei alle Reste gleicher Definition untereinander gleich oder verschieden sein können.

**4.** Gemisch nach Anspruch 1, dadurch gekennzeichnet, daß der Benzoxanthen- oder Benzothioxanthenfarbstoff eine Verbindung der Formel IV

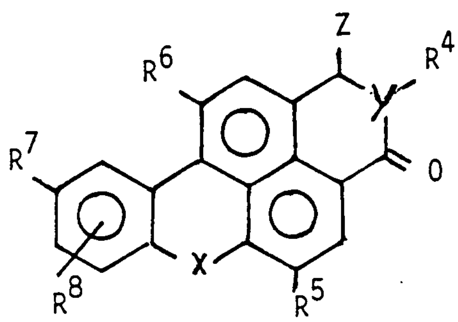

(IV)

ist, worin

- $R^4$ einen ggf. substituierten Alkyl-, Hydroxyalkyl-, Dialkylaminoalkyl- oder Arylrest,
- $R^5$ und $R^6$ Wasserstoff- oder Halogenatome oder ggf. substituierte Alkoxyreste,
- $R^7$ und $R^8$ Wasserstoff- oder Halogenatome, Nitrilgruppen, Alkyl-, Alkoxy-, Aryl- oder Alkoxycarbonylreste,
- X ein Sauerstoff- oder Schwefelatom und

entweder

- Y ein Kohlenstoffatom und
- Z eine Hydroxygruppe, einen ggf. substituierten Alkyl-, Alkoxy- oder Acyloxyrest, wobei zwischen Y und dem Y und Z verbindenden C-Atom eine Doppelbindung vorliegt,

oder

- Y ein Stickstoffatom und
- Z ein Carbonylsauerstoffatom bedeutet, wobei zwischen Y und dem Y und Z verbindenden C-Atom eine Einfachbindung vorliegt.

**5.** Gemisch nach einem der Ansprüche 2 und 3, dadurch gekennzeichnet, daß n = m ist.

**6.** Gemisch nach einem der Ansprüche 2 und 3, dadurch gekennzeichnet, daß $R^3 = CH_3$ ist.

**7.** Gemisch nach einem der Ansprüche 2 und 3, dadurch gekennzeichnet, daß a = 1 ist.

**8.** Gemisch nach Anspruch 1, dadurch gekennzeichnet, daß die durch Strahlung spaltbare Trihalogenmethylverbindung ein s-Triazin, das durch mindestens eine Trihalogenmethylgruppe und eine weitere Gruppe substituiert ist, oder ein Aryltrihalogenmethylsulfon ist.

**9.** Gemisch nach Anspruch 8, dadurch gekennzeichnet, daß die weitere Gruppe mindestens einen aromatischen Kern enthält, der direkt oder über ein durchkonjugiertes Doppelbindungssystem mit dem Triazinrest verbunden ist.

**10.** Gemisch nach Anspruch 1, dadurch gekennzeichnet, daß das Bindemittel wasserunlöslich und in wäßrigalkalischen Lösungen löslich ist.

**11.** Gemisch nach Anspruch 1, dadurch gekennzeichnet, daß es 10 bis 80 Gew.-% Acryl- oder Alkacrylsäureester, 20 bis 90 Gew.-% polymeres Bindemittel und 0,05 bis 20 Gew.-%, bezogen auf die nichtflüchtigen Bestandteile des Gemischs, an strahlungsaktivierbaren Polymerisationsinitiatoren (c) und (d) enthält.

**12.** Gemisch nach Anspruch 1, dadurch gekennzeichnet, daß es zusätzlich eine als Photoinitiator wirksame Acridin-, Phenazin- oder Chinoxalinverbindung enthält.

**13.** Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß Anspruch 1 besteht.

## Claims

**1.** A photopolymerizable mixture which contains, as essential components,
a) a polymeric binder,
b) an acrylate or alkacrylate of a polyhydric alcohol, and
c) a photoreducible dye as photoinitiator,
characterized in that it furthermore contains
d) a trihalomethyl compound which can be cleaved by irradiation,
that the photoreducible dye is a benzoxanthone dye or a benzothioxanthene dye, and that the acrylate or alkacrylate contains at least one group which is photooxidizable on excosure in the presence of the photoreducible dye.

**2.** A mixture as claimed in claim 1, characterized in that the acrylate or alkacrylate is a compound of the fomula I

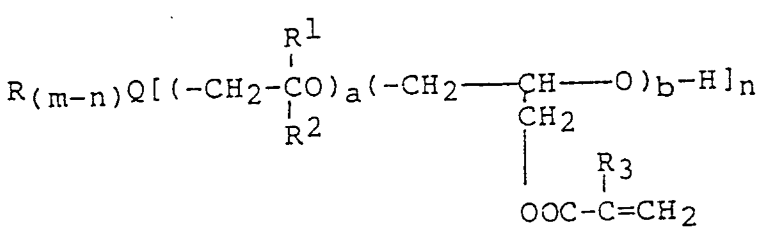

(I)

in which

Q denotes

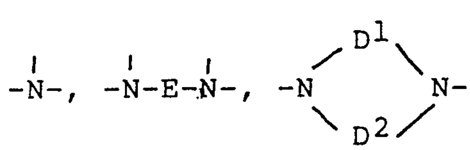

or -S-,

| | |
|---|---|
| R | denotes an alkyl, hydroxyalkyl or aryl group, |
| $R^1$ and $R^2$ | each denote a hydrogen atom, an alkyl group or an alkoxyalkyl group, |
| $R^3$ | denotes a hydrogen atom, a methyl group or an ethyl group, |
| $D^1$ and $D^2$ | each denote a saturated hydrocarbon group having 1 to 5 carbon atoms, |
| E | denotes a saturated hydrocarbon group having 2 to 12 carbon atoms, a cycloaliphatic group having 5 to 7 ring members and optionally containing up to two N, O or S atoms as ring members, an arylene group having 6 to 12 carbon atoms, a heterocyclic aromatic group having 5 or 6 ring members or a group or the formula II |

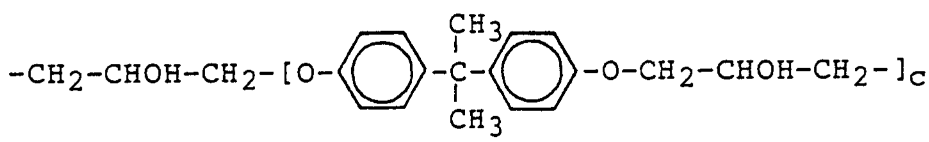
(II)

| | |
|---|---|
| a | denotes zero or an integer from 1 to 4, |
| b | denotes an integer from 1 to 4, |
| c | denotes an integer from 1 to 3, |
| m | denotes 2, 3 or 4, depending on the valency of Q, and |
| n | denotes an integer from 1 to m, |

whereby all radicals of the same definition may be identical to or different from one another.

**3.** A mixture as claimed in claim 1, characterized in that the acrylate or alkacrylate is a compound of the formula III

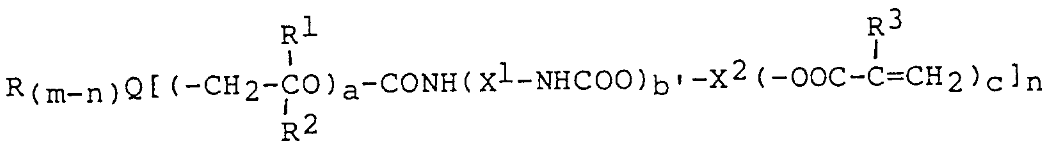
(III)

in which
$D^1$, $D^2$, E, Q, R, $R^1$, $R^2$, $R^3$, a, c, m and n have the meanings indicated for formula I of claim 2,

| | |
|---|---|
| $X^1$ | denotes a saturated hydrocarbon group having 2 to 12 carbon atoms, |
| $X^2$ | denotes a (c + 1)-valent saturated hydrocarbon group in which up to 5 methylene groups may be replaced by oxygen atoms, and |
| b' | denotes 0 or 1, |

it being possible for all radicals of the same definition to be identical to or different from one another.

**4.** A mixture as claimed in claim 1, characterized in that the benzoxanthene dye or benzothioxanthene dye is a compound of the formula IV

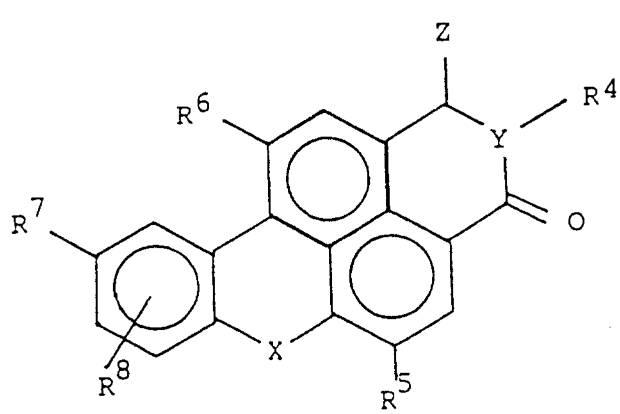
(IV)

in which

| | |
|---|---|
| $R^4$ | denotes an optionally substituted alkyl, hydroxyalkyl, dialkylaminoalkyl or aryl radical, |
| $R^5$ and $R^6$ | denote hydrogen or halogen atoms or optionally substituted alkoxy radicals, |
| $R^7$ and $R^8$ | denote hydrogen or halogen atoms or nitrile, alkyl, alkoxy, aryl or alkoxycarbonyl radicals, |
| X | denotes an oxygen or sulfur atom, and |

either

Y denotes a carbon atom and

Z denotes a hydroxy group or an optionally substituted alkyl, alkoxy or acyloxy radical, with a double bond existing between Y and the carbon atom by which Y and Z are linked,

or

Y denotes a nitrogen atom and

Z denotes a carbonyl oxygen atom, with a single bond existing between Y and the carbon atom by which Y and Z are linked.

**5.** A mixture as claimed in claim 2 or 3, wherein n = m.

**6.** A mixture as claimed in claim 2 or 3, wherein $R^3 = CH_3$.

**7.** A mixture as claimed in claim 2 or 3, wherein a = 1.

**8.** A mixture as claimed in claim 1, wherein the trihalomethyl compound which can be cleaved by irradiation is an s-triazine which is substituted by at least one trihalomethyl group and one further group or is an aryl trihalomethyl sulfone.

**9.** A mixture as claimed in claim 8, wherein the further group contains at least one aromatic nucleus which is connected to the triazine radical either directly or via a conjugated double bond system.

**10.** A mixture as claimed in claim 1, wherein the binder is insoluble in water and soluble in aqueous-alkaline solutions.

**11.** A mixture as claimed in claim 1, which contains 10 to 80 % by weight of acrylate or alkacrylate, 20 to 90 % by weight of polymeric binder and 0.05 to 20 % by weight, relative to the nonvolatile constituents of the mixture, of radiation-activatable polymerization initiators (c) and (d).

**12.** A mixture as claimed in claim 1, which additionally contains an acridine, phenazine or quinoxaline compound which acts as a photoinitiator.

**13.** A photopolymerizable recording material comprising a layer support and a photopolymerizable layer, wherein the photopolymerizable layer comprises a mixture as claimed in claim 1.

## Revendications

**1.** Composition photopolymérisable contenant en tant que composants essentiels

a) un liant polymère,

b) un ester acrylique ou alkacrylique d'un polyol et

c) un colorant photoréductible en tant que photo-initiateur,

caractérisée en ce qu'elle contient en outre

d) un composé trihalogénométhyle dissociable par irradiation,

en ce que le colorant photoréductible est un colorant benzoxanthène ou benzothioxanthène et en ce que l'ester acrylique ou alkacrylique comporte au moins un groupe photo-oxydable à l'insolation, en présence du colorant photoréductible.

**2.** Composition selon la revendication 1, caractérisée en ce que l'ester acrylique ou alkacrylique est un composé de formule I

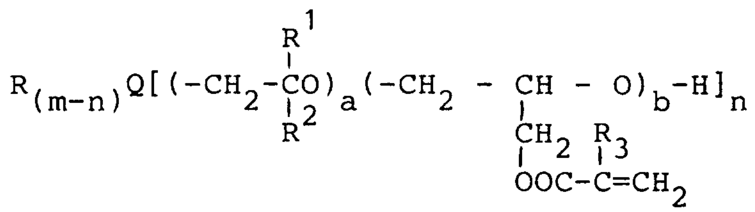 (I)

dans laquelle

Q représente

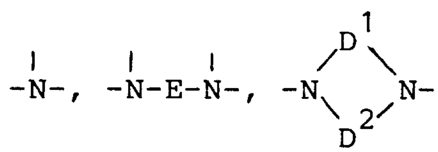

ou -S-,

R représente un groupe alkyle, hydroxyalkyle ou aryle,

$R^1$ et $R^2$ représentent chacun un atome d'hydrogène ou un groupe alkyle ou alcoxyalkyle,

$R^3$ représente un atome d'hydrogène ou le groupe méthyle ou éthyle,

$D^1$ et $D^2$ représentent chacun un groupe hydrocarboné saturé ayant de 1 à 5 atomes de carbone,

E représente un groupe hydrocarboné saturé ayant de 2 à 12 atomes de carbone, un groupe cycloaliphatique ayant de 5 à 7 chaînons formant le cycle, qui contient éventuellement jusqu'à deux atomes de N, O ou S en tant que chaînons formant le cycle, un groupe arylène ayant de 6 à 12 atomes de carbone, un groupe aromatique hétérocyclique à 5 ou 6 chaînons formant le cycle ou un groupe de formule II

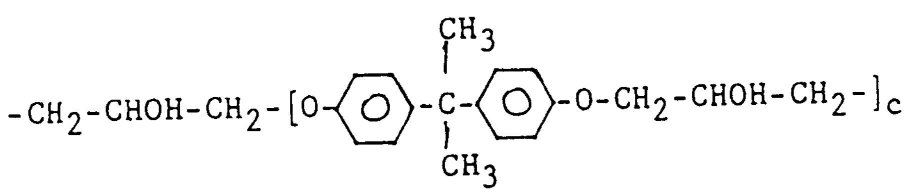 (II),

a est zéro ou un nombre entier allant de 1 à 4,

b est un nombre entier allant de 1 à 4,

c est un nombre entier allant de 1 à 3,

m est 2, 3 ou 4, selon la valence de Q, et

n est un nombre entier allant de 1 à m,

tous les radicaux de même définition pouvant être identiques ou différents les uns des autres.

**3.** Composition selon la revendication 1, caractérisée en ce que l'ester acrylique ou alkacrylique est un composé de formule III

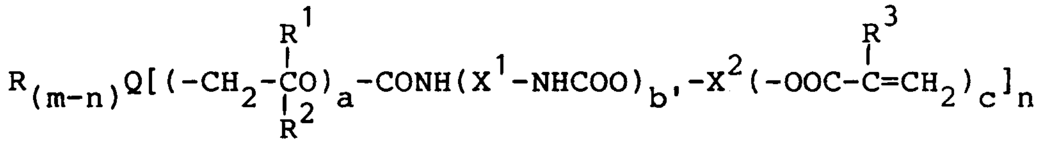 (III)

dans laquelle $D^1$, $D^2$, E, Q, R, $R^1$, $R^2$, $R^3$, a, c, m et n ont les mêmes significations que dans la formule I de la revendication 2,

$X^1$ représente un groupe hydrocarboné saturé ayant de 2 à 12 atomes de carbone,

$X^2$ représente un groupe hydrocarboné saturé (c+1)-valent dans lequel jusqu'à 5 groupes méthylène peuvent être remplacés par des atomes d'oxygène, et

b' est 0 ou 1,
tous les radicaux de même définition pouvant être identiques ou différents les uns des autres.

**4.** Composition selon la revendication 1, caractérisée en ce que le colorant benzoxanthène ou benzothioxanthène est un composé de formule IV

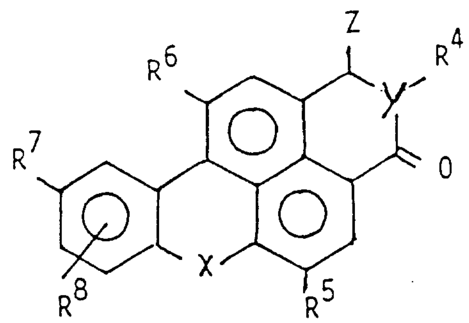

(IV)

dans laquelle

| | |
|---|---|
| $R^4$ | représente un radical alkyle, hydroxyalkyle, dialkylaminoalkyle ou aryle, éventuellement substitués, |
| $R^5$ et $R^6$ | représentent des atomes d'hydrogène ou d'halogène ou des radicaux alcoxy éventuellement substitués, |
| $R^7$ et $R^8$ | représentent des atomes d'hydrogène ou d'halogène ou des radicaux nitrile, alkyle, alcoxy, aryle ou alcoxycarbonyle, |
| X | représente un atome d'hydrogène ou de soufre, et |

soit

Y représente un atome de carbone et

Z représente le groupe hydroxy ou un radical alkyle, alcoxy ou acyloxy éventuellement substitués, une double liaison se trouvant entre Y et l'atome de carbone reliant Y et Z,

soit

Y représente un atome d'azote et

Z représente un atome d'oxygène en fonction carbonyle, une simple liaison se trouvant entre Y et l'atome de carbone reliant Y et Z.

**5.** Composition selon la revendication 2 ou 3, caractérisée en ce que n = m.

**6.** Composition selon la revendication 2 ou 3, caractérisée en ce que $R^3 = CH_3$.

**7.** Composition selon la revendication 2 ou 3, caractérisée en ce que a = 1.

**8.** Composition selon la revendication 1, caractérisée en ce que le composé trihalogénométhyle dissociable par irradiation est une triazine-s qui est substituée par au moins un groupe trihalogénométhyle et un autre groupe, ou une aryltrihalogénométhylsulfone.

**9.** Composition selon la revendication 8, caractérisée en ce que l'autre groupe contient au moins un noyau aromatique qui est lié au radical triazine directement ou par l'intermédiaire d'un système de doubles liaisons conjuguées.

**10.** Composition selon la revendication 1, caractérisée en ce que le liant est insoluble dans l'eau et soluble dans des solutions aqueuses-alcalines.

**11.** Composition selon la revendication 1, caractérisée en ce qu'elle contient de 10 à 80 % en poids d'ester acrylique ou alkacrylique, de 20 à 90 % en poids de liant polymère et de 0,05 à 20 % en poids, par rapport aux composants non volatils du mélange, d'initiateurs de polymérisation (c) et (d) activables par irradiation.

**12.** Composition selon la revendication 1, caractérisée en ce qu'elle contient en outre un composé acridine, phénazine ou quinoxaline actif en tant que photo-initiateur.

**13.** Matériau de reprographie photopolymérisable comportant un support de couche et une couche photopolymérisable, caractérisé en ce que la couche photopolymérisable est constituée d'une composition selon la revendication 1.